(19) Europäisches Patentamt
European Patent Office
Office européen des brevets

(11) **EP 2 017 867 B1**

(12) **EUROPÄISCHE PATENTSCHRIFT**

(45) Veröffentlichungstag und Bekanntmachung des Hinweises auf die Patenterteilung:
**15.09.2010 Patentblatt 2010/37**

(21) Anmeldenummer: **08017535.9**

(22) Anmeldetag: **28.07.2006**

(51) Int Cl.:
*G01R 19/25* (2006.01)     *H01H 47/00* (2006.01)
*G05B 9/03* (2006.01)     *H02H 1/04* (2006.01)
*H02P 23/00* (2006.01)     *H02P 1/28* (2006.01)
*H01H 9/56* (2006.01)

(54) **Messvorrichtung zum Messen eines periodischen Analogsignals**

Measuring device for measuring a periodic analogue signal

Dispositif de mesure destiné à la mesure d'un signal analogique périodique

(84) Benannte Vertragsstaaten:
**DE FR IT**

(30) Priorität: **02.08.2005 DE 102005036777**
**23.09.2005 DE 102005045753**
**12.01.2006 DE 102006001805**

(43) Veröffentlichungstag der Anmeldung:
**21.01.2009 Patentblatt 2009/04**

(62) Dokumentnummer(n) der früheren Anmeldung(en) nach Art. 76 EPÜ:
**06762897.4 / 1 911 058**

(73) Patentinhaber: **Phoenix Contact GmbH & Co. KG**
**32825 Blomberg (DE)**

(72) Erfinder: **Korrek, Andre**
**37696 Marienmünster (DE)**

(74) Vertreter: **Blumbach - Zinngrebe**
**Patentanwälte**
**Alexandrastrasse 5**
**65187 Wiesbaden (DE)**

(56) Entgegenhaltungen:
**EP-A- 1 132 744     US-A- 4 625 283**
**US-A- 4 630 218**

**Beschreibung**

Die Erfindung betrifft **eine Messvorrichtung sowie ein Verfahren zum Messen periodischer Ausgangssignale.**

Der Schutz elektrischer Antriebe, wie zum Beispiel Motoren, gegen Überströme oder Überspannungen erfolgt heute vornehmlich durch mechanische Überwachungselemente auf Basis von Bimetallen. Die Auslösecharakteristik von mechanischen Bimetallen wird dabei durch die verwendeten Metalle sowie den Wärmeübertragung der vom Motorstrom durchflossenen Glühkerzen bestimmt. Obwohl temperaturabhängige Kompensationsschaltungen eingesetzt werden, kann das Auslöseverhalten mechanischer Bimetalle durch Schwankungen der Umgebungstemperatur verfälscht werden. Darüber hinaus sind derartige mechanische Überwachungselemente extrem anfällig gegenüber Verschmutzungen und Verschleiß ihrer Komponenten, so dass Überwachungselemente häufig geprüft und gewartet werden müssen.

Demzufolge wurden in den vergangenen Jahren immer häufiger elektronische Bimetallschalter als Überwachungselemente eingesetzt. Diese arbeiten wesentlich präziser und haben im Vergleich zu mechanischen Überwachungselementen keinen nennenswerten Verschleiß und sind unempfindlicher gegenüber äußeren Beeinflussungen.

Allerdings werden bei der Verwendung elektronischer Bimetallschalter Messgeräte eingesetzt, die bei der Auslösung der elektronischen Bimetallschalter erforderlich sind. Die eingesetzten Messgeräte müssen unter anderem den sogenannten "Inrush" erfassen können, der das Siebenfache des Motornennstroms betragen kann, und ferner auch im Nennstrombereich eines Motors noch eine ausreichende Auflösung und Genauigkeit besitzen. Demzufolge ist eine aufwendige und komplexe Dimensionierung der Messgeräte erforderlich, damit sie Ströme innerhalb eines möglichst großen Strombereichs, d. h. Nennströme und Überströme erfassen können. Dies führt zu sehr großen und teuren Messgeräten, da insbesondere die Stromwandler entsprechend überdimensioniert werden müssen.

**Eine Messvorrichtung gemäß dem Oberbegriff des Anspruchs 1 ist zum Beispiel aus der** US-A-4 625 283 **oder der** US-A- 4 630 218 **bekannt.**

Der Erfindung liegt die Aufgabe zugrunde, ein Messverfahren und eine Messvorrichtung zur Verfügung zu stellen, mit denen Überströme erfasst werden können, obwohl die Messvorrichtung nur für den Nennstrombereich einer elektrischen Einrichtung ausgelegt ist und demzufolge mit kostengünstigen elektrischen und elektromagnetischen Baukomponenten aufgebaut werden kann.

Diese Aufgabe wird durch eine Messvorrichtung gemäß Anspruch 1 oder 3, oder durch ein Verfahren gemäß Anspruch 8 oder 9 gelöst.

Hierzu ist eine Messvorrichtung zum Messen eines periodischen analogen Signals vorgesehen, dessen Amplitude außerhalb eines vorbestimmten Arbeitsbereichs liegen kann. Die Messvorrichtung weist eine Einrichtung zum Ermitteln der Zeitdauer, während der die Amplitude des zu messenden Analogsignals betragsmäßig größer oder gleich einem vorbestimmten Schwellenwert ist, sowie eine Auswerteeinrichtung auf, die aus der ermittelten Zeitdauer und der Signalform, insbesondere der Signalfrequenz des zu messenden Analogsignals dessen maximale Amplitude berechnet.

An dieser Stelle sei erwähnt, dass unter "vorbestimmten Arbeitsbereich" der Bereich zu versehen ist, innerhalb dessen Messsignale das Messgerät, d. h. ein oder mehrere elektrische Komponenten, aus denen das Messgerät aufgebaut ist, nicht in die Sättigung fahren und somit in herkömmlicher Weise gemessen werden können. Der Begriff "betragsmäßig größer" berücksichtigt den Umstand, dass ein periodisches Analogsignal einen maximalen und minimalen Spitzenwert aufweist, der über- bzw. unterschritten werden kann.

Die Ermittlungseinrichtung der Messvorrichtung **weist** eine Abtasteinrichtung zum Abtasten des zu messenden Analogsignals mit einer Abtastfrequenz sowie eine Einrichtung zum Erfassen und Zählen von aufeinander folgenden Abtastwerten auf, welche betragsmäßig größer oder gleich dem vorbestimmten Schwellenwert sind. In diesem Fall ist die Auswerteeinrichtung zum Berechnen der maximalen Amplitude des Analogsignals in Abhängigkeit von der Anzahl der gezählten Abtastwerte, der Abtastfrequenz und der Signalfrequenz ausgebildet.

An dieser Stelle sei erwähnt, dass der Schwellwert zum Beispiel der obere und/oder untere Grenzwert des vorbestimmten Arbeitsbereichs der Messvorrichtung sein kann, innerhalb dessen eine herkömmliche Messung des Analogsignals möglich ist. Allerdings kann der Schwellwert auch um einen vorbestimmten Betrag betragsmäßig kleiner als der obere und/oder untere Grenzwerte sein.

Handelt es sich bei dem Analogsignal um ein sinusförmiges Signal mit einer vorbestimmten Signalfrequenz, so kann die Auswerteeinrichtung den maximalen Amplitudenwert unter Verwendung der Gleichung

$$I = \frac{1}{\sin\left(\pi\left(\frac{1}{2} - \frac{T_{AB} * N}{T}\right)\right)}$$

berechnen. In der Gleichung ist $T_{AB}$ der Kehrwert der Abtastfrequenz, N die Anzahl gezählter Abtastwerte, welche betragsmäßig größer oder gleich dem vorbestimmten Schwellenwert sind, und T die Periodendauer des zu messenden Analogsignals ist.

Um die Rechenleistung der Auswerteeinrichtung reduzieren zu können, ist eine alternative Messvorrichtung vorgesehen, wie sie in Anspruch 3 umschrieben ist.

Danach weist die Messvorrichtung eine Einrichtung zum Abtasten des Analogsignals mit einer Abtastfrequenz auf. Ferner ist eine Einrichtung zum Erfassen und Zählen von aufeinander folgenden Abtastwerten, welche betragsmäßig größer oder gleich einem vorbestimmten Schwellenwert sind, vorgesehen. In einer Speichereinrichtung sind der maximale, außerhalb des vorbestimmten Arbeitsbereichs liegende Amplitudenwert mehrerer Referenzsignale und die jeweils dazu gehörende Anzahl von gezählten Abtastwerten, welche betragsmäßig größer oder gleich einem vorbestimmten Schwellenwert sind, abgelegt. Ferner weist die Messvorrichtung eine Auswerteeinrichtung auf, die unter Ansprechen auf die von der Erfassungs- und Zähleinrichtung ermittelte Anzahl von Abtastwerten den dazu gehörenden maximalen Amplitudenwert aus der Speichereinrichtung ausliest. Hierzu kann die ermittelte Anzahl als Speicheradresse verwendet. An dieser Stelle sei betont, dass es sich bei dem maximalen Amplitudenwert um einen berechneten Amplitudenwert handelt, der als Schätzwert für den tatsächlichen maximalen Amplitudenwert anzusehen ist, welcher ein zu messendes Signal, welches außerhalb des vorbestimmten Arbeitsbereichs liegt, hat.

Um die Abtastwerte digital auswerten zu können, ist ein AD-Umsetzer zum Umsetzen der Abtastwerte in entsprechende Digitalwerte vorgesehen.

Der maximale Amplitudenwert kann um-so genauer berechnet werden, je höher die Abtastfrequenz der Abtasteinrichtung gewählt wird. Gleichzeitig nimmt jedoch der Rechenaufwand zu. Demzufolge ist es zweckmäßig, dass die Abtastfrequenz einstellbar ist.

Die in den Ansprüchen umschriebene Messvorrichtung kann in einer gegen Überströme gesicherten Vorrichtung, insbesondere bei elektrischen Antrieben, zum Einsatz kommen, wobei die gegen Überströme gesicherte Vorrichtung eine Auslöseeinrichtung aufweist, die unter Ansprechen auf den berechneten maximalen Amplitudenwert die Vorrichtung ausschalten kann.

Das obengenannte technische Problem wird ebenfalls durch ein Verfahren zum Messen eines periodischen Analogsignals gelöst, dessen Amplitude außerhalb eines vorbestimmten Arbeitsbereichs liegen kann, zur Verfügung gestellt. Zunächst wird die Zeitdauer, während der die Amplitude des zu messenden Analogsignals betragsmäßig größer oder gleich einem vorbestimmten Schwellenwert ist, ermittelt. In Abhängigkeit von der ermittelten Zeitdauer und der Signalform, insbesondere der Signalfrequenz des zu messenden Messsignals, wird dann die maximale Amplitude des zu messenden Analogsignals, welches außerhalb des vorbestimmten Arbeitsbereichs liegt, berechnet.

Die Zeitdauer wird ermittelt, indem das zu messende Analogsignal mit einer Abtastfrequenz abgetastet wird. Aufeinander folgende Abtastwerte, welche betragsmäßig größer oder gleich einem vorbestimmten Schwellenwert sind, werden dann gezählt. In Abhängigkeit von der Anzahl der gezählten Abtastwerte, der Abtastfrequenz und der Signalfrequenz wird die maximale Amplitude des Analogsignals berechnet.

Um den schaltungstechnischen Aufwand und den Zeitaufwand beim Berechnen des maximalen Amplitudenwertes zu reduzieren, können vorab für mehrere Referenzsignale jeweils die maximale Amplitude, welche außerhalb des vorbestimmten Arbeitsbereichs liegt, und die dazu gehörende Anzahl von Abtastwerten, die betragmäßig größer oder gleich einem Schwellenwert sind, ermittelt und gespeichert werden. Nunmehr wird ein zu messendes Analogsignal mit einer Abtastfrequenz abgetastet. Die aufeinander folgenden Abtastwerte, welche betragsmäßig größer oder gleich dem vorbestimmten Schwellenwert sind, werden gezählt, und der zur Anzahl der gezählten Abtastwerte gehörende maximale Amplitudenwert wird ausgelesen.

Die Erfindung wird nachfolgend anhand mehrerer Ausführungsbeispiele in Verbindung mit den beiliegenden Zeichnungen näher erläutert. In den Zeichnungen werden für gleiche Bauteile oder Komponenten die gleichen Bezugszeichen verwendet. Es zeigen:

Fig. 1     ein Sicherheitsschaltgerät gemäß der Erfindung,

Fig. 2     ein Ausführungsbeispiel eines Messgeräts nach der Erfindung,

Fig. 3     ein abgetastetes Messsignal innerhalb des zulässigen Messbereichs,

Fig. 4     ein abgetastetes Messsignal, das außerhalb des zulässigen Messbereichs liegt,

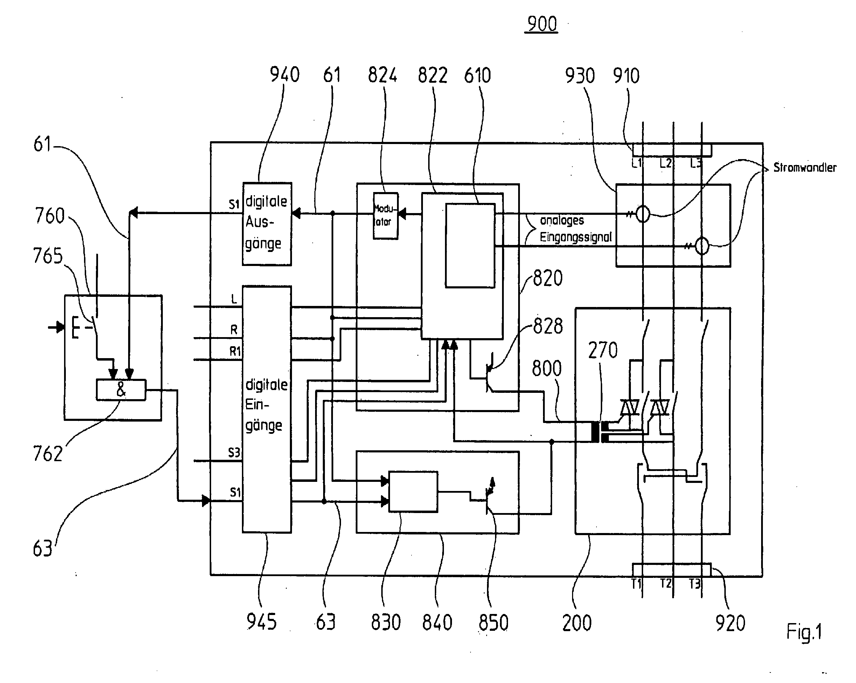

In Fig. 1 ist das Blockschaltbild eines beispielhaften Sicherheitsschaltgeräts 900 dargestellt, dessen Komponenten in einem Gehäuse untergebracht sein können. Das Sicherheitsschaltgerät 900 weist eine erste Anschlusseinrichtung 910 auf, über die das Sicherheitsschaltgerät 900 beispielsweise an ein dreiphasiges Energieversorgungsnetz (nicht dargestellt) angeschaltet werden kann. Die drei mit dem Energieversorgungsnetz verbundenen Eingangsleiter sind in Fig. 1 mit L1, L2 und L3 bezeichnet. Die drei Leiter L1, L2 und L3 sind mit einer Leistungsendstufe 200 verbunden, deren drei ausgangsseitigen Leiter T1, T2 und T3 bezeichnet sind. Die drei ausgangseitigen Leiter sind mit einer zweiten Anschlusseinrichtung 920 verbunden, an die eine sicherheitstechnische Einrichtung, beispielsweise ein Drehstrommotor angeschlossen werden kann. Denkbar ist es, dass an das Sicherheitsschaltgerät 900 auch mehrere sicherheitstechnische Einrichtungen, wie z. B. ein- oder weitere mehrphasige Antriebe angeschlossen werden können. Dementsprechend ist die verwendete Leistungsendstufe ein- oder mehrphasig ausgebildet. Die Leistungsendstufe 200 ist der einfachen Darstellung wegen nur schematisch dargestellt.

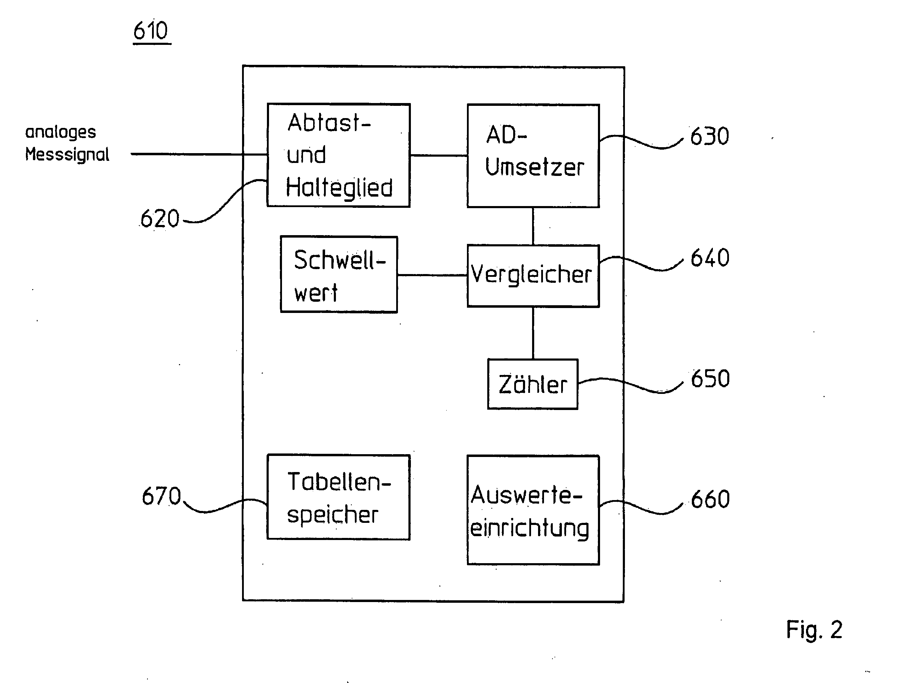

In die Eingangsleiter L1, L2 und L3 ist eine Einrichtung 930 mit Stromwandlern in den Leitern L1 und L3 geschaltet, die den analogen Strom in den Leitern L1 und L3 einer Messeinrichtung 610 zuführen. Die Messeinrichtung 610 kann Bestandteil einer programmierbaren Steuereinheit, zum Beispiel eines Mikrocontrollers oder Mikroprozessors 822 einer Steuereinrichtung 820 sein. Sie kann jedoch auch als separates Funktionsmodul ausgebildet sein. Bei der Messeinrichtung 610 handelt es sich vorzugsweise um die in Verbindung mit Fig. 2 erläuterte Messeinrichtung 610. Hauptaufgabe der Messeinrichtung ist darin zu sehen, festzustellen, ob die Amplitude der Ströme in den Leitern L1 und L3 außerhalb eines vorbestimmten Arbeitsbereichs liegen. Wenn dies der Fall ist, steuert der Mikroprozessor 822 über einen Schalttransistor 828 die Leistungsendstufe 200 ab, um den angeschalteten Drehstrommotor von dem nicht dargestellten Energieversorgungsnetz zu trennen. Wie in der Fig. 1 schematisch dargestellt, ist der Schalttransistor 828 mit einem Übertrager 270 der Leistungsendstufe 200 verbunden. Alternativ oder zusätzlich ist es möglich, in die Leiter L1 und L3 Spannungswandler einzuschleifen, die Leiterspannungen der Messeinrichtung 610 zuführen. Die Messeinrichtung 610 kann derart ausgebildet sein, dass sie aus den empfangenen Spannungssignalen durch die Multiplikation mit den zugehörigen Stromsignalen die Wirkleistung ermittelt und prüft, ob die Wirkleistungen innerhalb oder außerhalb eines vorbestimmten Arbeitsbereichs liegen. Die tatsächlichen Werte des Arbeitsbereiches und die Zeitdauer, wie lange die Stromamplituden außerhalb des vorbestimmten Arbeitsbereiches liegen dürfen, ohne dass eine Abschaltung des Drehstrommotors erfolgt, können von einer Bedienperson eingestellt werden.

Weiterhin umfasst das Sicherheitsschaltgerät 900 eine weitere Steuereinrichtung 840, die einen Demodulator 840 und einen Schalttransistor 850 aufweist, der mit einem anderen Ende des Übertragers 270 der Leistungsendstufe 200 verbunden ist.

Dem Mikroprozessor 822 der ersten mikroprozessor gesteuerten Steuereinrichtung 820 ist ein Modulator 824 zugeordnet, dessen Ausgangssignal über einen digitalen Ausgang einer Schnittstelle 940 einer extern an das Sicherheitsschaltgerät 900 angeschlossenen Eingangsstufe 760 zugeführt wird. Das Ausgangssignal der zweiten Steuereinrichtung 840 wird ebenfalls dem Mikroprozessor 822 zugeführt, der unter Ansprechen auf das empfangene Ausgangssignal die ordnungsgemäße Funktionsweise der zweiten Steuereinrichtung 840 überprüfen kann. Der Mikroprozessor 822 erzeugt in Verbindung mit dem Modulator 824 ein Überwachungssignal, welches signalisiert, ob die beiden Steuereinrichtungen 820 und 840 ordnungsgemäß arbeiten. Um sicherstellen zu können, dass der an das Sicherheitsschaltgerät 900 angeschaltete Drehstrommotor in einen sicheren Zustand gefahren werden kann, wenn entweder Schaltungskomponenten des Sicherheitsschaltgerätes 900, insbesondere die Steuereinrichtungen 820 und 840, defekt sind, oder von extern beispielsweise ein in der Eingangsstufe 760 implementierter Notausschalter 765 betätigt wird, wird sowohl das Eingangssignal des Notausschalters 765 als auch das Ausgangssignal des Modulators 824 einer Verknüpfungseinrichtung 762, welche beispielsweise ein UND-Gatter sein kann, zugeführt. Das Ausgangssignal der Verknüpfungseinrichtung 762 der Eingangsstufe 760 wird über eine Verbindung 63 einem digitalen Eingang einer Schnittstelle 945 des Sicherheitsschaltgerätes 900 zugeführt. Über die Schnittstelle 945 gelangt das Eingangssignal über eine Verbindung 63' zum Demodulator 830 der zweiten Steuereinrichtung 840 und zum Mikroprozessor 822. Erkennt der Demodulator 830 der Steuereinrichtung 840 oder der Mikroprozessor 822 der Steuereinrichtung 820, dass das vom Modulator 824 erzeugte Überwachungssignal einen Systemfehler signalisiert und/oder der Notausschalter 762 betätigt worden ist, so werden die jeweiligen Schalttransistoren 828 und 850 angesteuert, um die Leistungsendstufe 200 aufzutrennen, so dass die Energieversorgung über die Leiter L1, L2 und L3 zu den Ausgangsleitern T1, T2 und T3 und somit zum angeschlossenen Drehstrommotor unterbrochen wird.

An dieser Stelle sei angeführt, dass die in Fig. 1 gezeigte Eingangsstufe 760 lediglich der einfachen Darstellung wegen nur einen Schalter 765 enthält, der einen Notausschalter symbolisiert. Denkbar ist auch, einen Notausschalter mit mehreren Schaltern zu verwenden, wobei die Schalter in diesem Fall jeweils mit einem separaten Ausgang der Schnittstelle 940 und einem separaten Eingang der Schnittstelle 945 verbunden sein können. Ferner ist denkbar, dass die Eingangsstufe 760 alternativ oder zusätzlich zu einem Notausschalters, eine Schutztür, und/oder einen Zweihand-Schalter aufweisen kann.

Dank dieser besonderen Maßnahmen ist das Sicherheitsschaltgerät 900 in der Lage, eine komplexe und vielfältige sicherheitstechnische Überwachung einer an das Sicherheitsschaltgerät 900 angeschalteten sicherheitstechnischen Einrichtung, beispielsweise eines Drehstrommotors zu übernehmen. In einer besonders zweckmäßigen Ausführungsform sind die Anschlußeinrichtungen 910 und 920, die Leistungsendstufe 200, die Bauteile der Steuereinrichtung 820 und 850 sowie die Schnittstellen 940 und 945 auf einer Leiterplatte (nicht dargestellt angeordnet. Demzufolge muß bei der Implementierung einer Anlage mit sicherheitstechnischen Einrichtungen lediglich dafür gesorgt werden, dass die sicherheitstechnische Einrichtung mit dem Sicherheitsschaltgerät 900 verbunden wird. Die Bedienperson muß sich nicht darum kümmern, wie die sicherheitstechnische Einrichtung an die jeweiligen Motorschutzschalter und Schutzrelais und ggfs. an einen Notauschalter angeschlossen werden muß. Die Gefahr von Fehlverdrahtungen ist somit deutlich gegenüber den bekannten Maßnahmen reduziert.

Weiterhin kann die Schnittstelle 945 zwei digitale Eingänge aufweisen, an die zwei Leitungen R und L angeschlossen sind, über die Steuersignale für den Rechts- oder Linkslauf eines Drehstrommotors angelegt werden können. Die Steuersignale werden ebenfalls dem Mikroprozessor 822 zugeführt, der die Leistungsendstufe entsprechend ansteuert. Die einzelnen Verbindungsleitungen sind der besseren Übersichtlichkeit wegen nicht in der Fig. 1 dargestellt. Weiterhin weist die Schnittstelle 945 einen weiteren Eingang R1 auf, an den ein nicht dargestellter Reset-Taster angeschlossen werden kann. Beispielsweise kann die Flanke eines angelegten Reset-Signals vom Mikroprozessor 822 detektiert werden, der daraufhin die Leistungsendstufe 200 ansteuert, um nach Abschaltung des Drehstrommotors infolge eines Fehlers den Drehstrommotor wieder in Betrieb zu nehmen.

Messvorrichtung

Fig. 2 zeigt das beispielhafte Messgerät 610, welches beispielsweise zur Messung sinusförmiger Ströme geeignet ist. Das Messgerät 610 dient nicht nur dazu, Nennströme, d. h. Ströme innerhalb eines vorbestimmten und zulässigen Arbeitsbereichs zu messen. Es dient auch dazu, bei Auftreten eines Überstroms, der außerhalb des zulässigen Arbeitsbereichs des Messgerätes 610 liegt, einen Wert für den tatsächlichen Spitzenwert des Überstroms zu ermitteln. Das Messgerät 610 und dessen Komponenten, insbesondere ein Stromwandler, können deshalb hinsichtlich des maximalen Nennstroms eines Motors dimensioniert sein und somit erheblich kleiner und kostengünstiger hergestellt werden, als Messgeräte, die auch Überströme, die das Siebenfache des Motornennstroms betragen können, messen können.

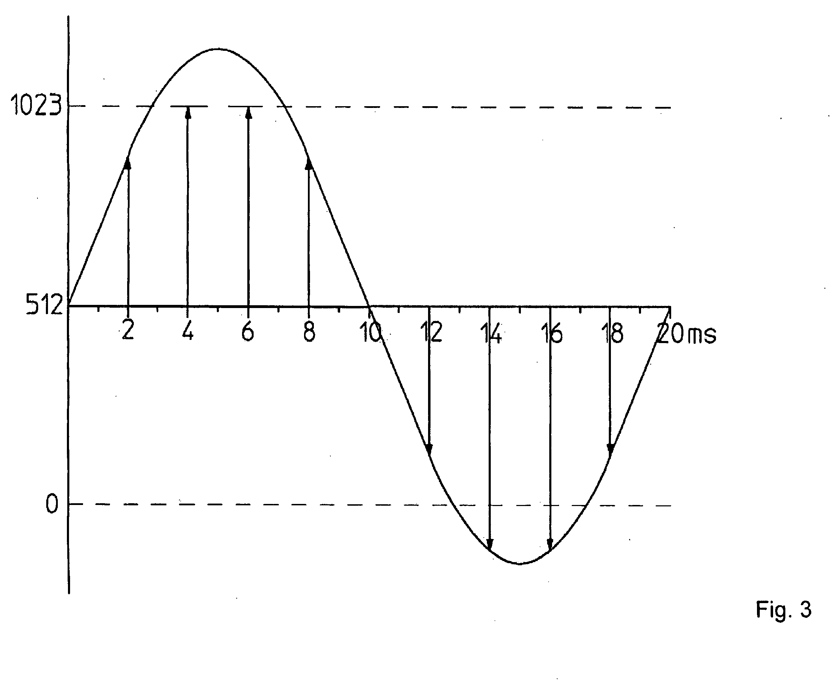

Hierzu kann das Messgerät 610 eingangsseitig ein Abtast- und Halteglied 620 aufweisen, an welches das beispielsweise vom Leiter L1 des Sicherheitsschaltgerätes 900 abgezweigte, zu messende periodische Analogsignal angelegt werden kann. Das Abtast- und Halteglied 620 tastet ein zu messendes Analogsignal mit einer vorbestimmten Abtastfrequenz ab, welche einstellbar sein kann. Der Ausgang des Abtast- und Halteglieds 620, an dem analoge Abtastproben des zu messenden Analogsignals anliegen, werden einem AD-Umsetzer 630 zugeführt, welcher die Abtastproben in die dazu gehörenden Digitalwörter umsetzt. Zum Beispiel kann der AD-Umsetzer 630 aus den angelegten Abtastwerten Digitalwerte mit der Länge von 610 Bits erzeugen. Bei einem solchen 10 Bit AD-Umsetzer werden die analogen Abtastproben jeweils in eine Folge von 10 Bits umgesetzt, die wiederum in die entsprechende Dezimalzahl, die zwischen zwischen 0 und 1023 liegt, umgewandelt werden kann. Hierbei entspricht zum Beispiel der dezimale Wert 0 dem kleinsten und der dezimale Zahlenwert 1023 dem größten Stromwert innerhalb des zulässigen Arbeitsbereichs, sofern die Nulllinie eines sinusförmigen Signals dem dezimalen Zahlenwert 512 zugeordnet wird. Ein solcher Fall ist in Fig. 3 dargestellt.

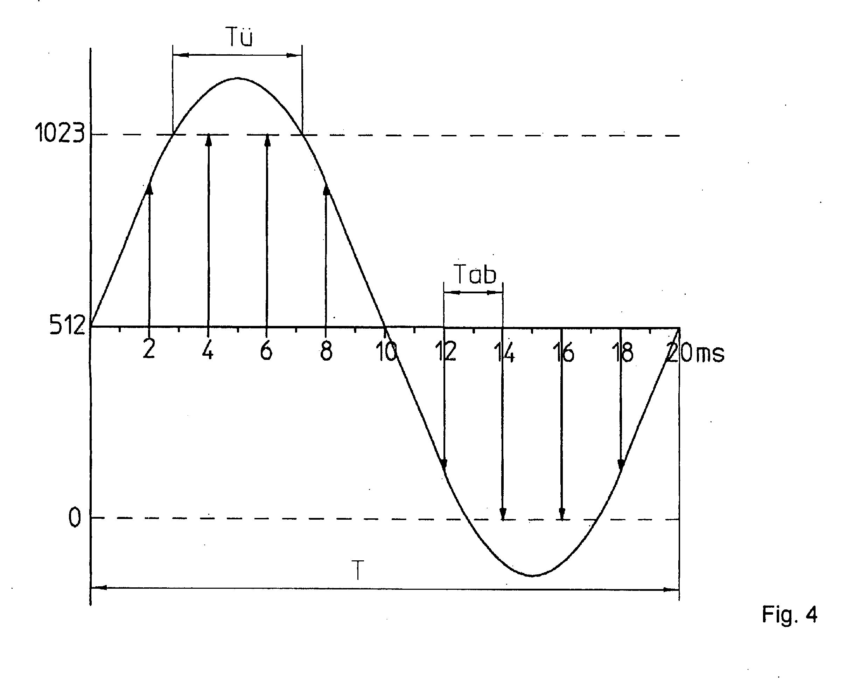

Der Ausgang des AD-Umsetzers 630 ist mit dem Eingang eines Vergleichers 640 verbunden, in dem beispielsweise die im AD-Umsetzer 630 gebildeten dezimalen Zahlenwerte der Abtastproben eines Messsignals mit einem Schwellenwert verglichen werden. Im vorliegenden Beispiel sei angenommen, dass der Schwellenwert mit dem oberen und/oder unteren Grenzwert des zulässigen Arbeitsbereichs des Messgeräts 610, d. h. dem dezimalen Wert 1023 und/oder dem dezimalen Wert 0 zusammenfällt, wie dies in den Fig. 3 und 4 durch die gestrichelten Linien dargestellt ist. Der Ausgang des Vergleichers 40 ist mit einem Zähler 650 verbunden, der zählt, wie viele aufeinander folgende Zahlenwerte dem Schwellenwert 1023 und/oder 0 entsprechen. Eine Auswerteeinrichtung 660 ist mit dem Ausgang des Zählers 650 verbunden. Wie später noch ausführlicher dargelegt wird, dient die Auswerteeinrichtung 660 dazu, den maximalen Amplitudenwert, d. h. den Spitzenwert des zu messenden Analogsignals, welches sich außerhalb des Arbeitsbereichs des Messgeräts 610 befindet, zu ermitteln.

Gemäß einer alternativen Ausführungsform sind die entsprechenden, zur Ermittlung der maximalen Amplitude erforderlichen Werte vorab in einem Tabellenspeicher 670 abgelegt worden, auf den die Auswerteeinrichtung 660 zugreifen kann.

Nachfolgend wird die Funktionsweise des in Fig. 2 dargestellten Messgeräts 610 anhand von zwei Ausführungsbeispielen näher erläutert.

Zunächst betrachten wir Fig. 3. In Fig. 3 ist ein zu messender Wechselstrom mit einer Periodendauer von 20 ms dargestellt, der im Abtast- und Halteglied 620 mit einer Abtastfrequenz von 50 kHz (f=1/2ms) abgetastet wird. Die Abtastproben sind als Pfeile im Abstand von 2ms in der Fig. 3 dargestellt. Es ist zu beachten, dass der Messtrom sich innerhalb des zulässigen Messbereichs des Messgeräts 610 befindet. Die zulässige Ober- und Untergrenze des Mess- oder Arbeitsbereichs sind gestrichelt dargestellt und den beiden Dezimalwerten 0 und 1023 zugeordnet. So lange das zu messende Signal innerhalb dieses Messbereichs liegt, arbeitet das Messgerät 610 in dem herkömmlichen Messmodus. Überschreitet, wie in Fig. 4 dargestellt, das Messsignal den zulässigen Messbereich, so kann der AD-Umsetzer 630, der nur für den zulässigen Arbeitsbereich dimensioniert ist, das Signal nicht mehr korrekt auflösen und geht in dieo Sättigung. Dies führt dazu, dass die Abtastproben, die außerhalb des zulässigen Messbereichs liegen, allesamt durch den maximalen und minimalen Zahlenwert, d. h. 1023 bzw. 0, dargestellt werden. In diesem Moment geht das Messgerät 610 in seinen zweiten Modus, in dem der Spitzenwert des außerhalb des zulässigen Arbeitsbereichs liegenden Messstroms ermittelt wird. Nachfolgend werden zwei Ausführungsvarianten zur Ermittlung des Spitzenwertes beschrieben.

Bei dem Messsignal handelt es sich um eine sinusförmige Eingangsgröße, die bekanntlich durch die Gleichung

$$i(t) \;=\; I * \sin(\omega \dot{+} t) \tag{1}$$

beschrieben werden kann, wobei I die Amplitude des Messsignals ist. Die Amplitude ergibt sich demnach durch die Gleichung

$$I = \frac{i(t)}{\sin(\omega t)} \cdot \tag{2}$$

Sind die Periodendauer des Messsignals und die Zeitdauer $T_u$, die nachfolgend auch Überstromdauer genannt wird und angibt, wie lange das Messsignal den zulässigen Messbereich überschreitet, bekannt, kann die maximale Amplitude durch die Gleichung

$$I = \frac{1}{\sin\left(\pi\left(\frac{1}{2} - \frac{T_0 * N}{T}\right)\right)} \tag{3}$$

berechnet werden, wobei
i(t) = 1 für den Nennbereich gilt,
$\omega = 2\pi/T$, und T die Periodendauer des Messsignals ist,
t = T/4 - $T_ü$/2, und $T_ü$ die Überstromdauer ist.
Die sogenannte Überstromdauer $T_ü$ kann jedoch nicht unmittelbar gemessen werden.
Sie kann jedoch beispielsweise aus der Anzahl der Abtastwerte, die betragsmäßig größer oder gleich einem vorgegebenen Schwellenwert sind, berechnet werden. Im vorliegenden Beispiel sei angenommen, dass der Schwellenwert mit dem Zahlenwert 1023, der den oberen Grenzwert des zulässigen Messbereichs darstellt, übereinstimmt. Ist ferner die Abtastfrequenz 1/$T_{ab}$ des Abtast- und Halteglieds 620 bekannt, kann die Überstromdauer $T_ü$ durch die Gleichung

$$T_ü \;=\; N * T_{AB} \tag{4}$$

berechnet werden. Je genauer die Überstromzeit $T_ü$ bestimmt werden kann, d. h. je kleiner das Abtastintervall $T_{AB}$ ist, desto genauer kann die maximale Überstromamplitude I berechnet werden.
Wird Gleichung (4) in Gleichung (3) eingesetzt, so ergibt sich die Berechnungsvorschrift

$$I = \frac{1}{\sin\left(\pi\left(\frac{1}{2} - \frac{T_{AB} * N}{T}\right)\right)}, \tag{5}$$

mit der die Auswerteeinrichtung 660 die maximale Überstromamplitude I des Messsignals berechnen kann.

Wir kehren zur weiteren Erläuterung der Funktionsweise des Messgeräts 610 zu Fig. 4 zurück.

Deutlich sichtbar überschreitet die tatsächliche Amplitude des an den Eingang des Messgeräts 610 angelegten Messstroms den oberen und unteren Grenzwert des zulässigen Messbereichs für die Überstromdauer $T_{ü}$. Der obere Grenzwert 1023 entspricht in diesem Beispiel auch dem Schwellenwert, der vom Vergleicher 640 benötigt wird, um die Abtastwerte zu ermitteln, die außerhalb des zulässigen Messbereichs liegen.

In Fig. 4 ist sowohl die Periodendauer T des zu messenden sinusförmigen Signals, welche 20 ms beträgt, als auch die zeitliche Dauer $T_{AB}$ zwischen zwei aufeinander folgenden Abtastwerten, welche 2 ms beträgt, dargestellt. Bei dem in Fig. 8 dargestellten Kurvenverlauf ergibt sich, dass der der AD-Umsetzer 30 infolge einer Übersteuerung dem zweiten und dritten Abtastwert den maximalen Zahlenwert 1023 zuordnet. Die den Abtastwerten zugeordneten Zahlenwerte werden dem Vergleicher 640 zugeführt, der die Zahlenwerte mit dem Schwellenwert 1023 vergleicht. Der Vergleicher 640 stellt fest, dass zwei aufeinander folgende Abtastwerte, die nach 4 ms und 6 ms abgetastet worden sind, den maximalen Zahlenwert 1023 angenommen haben. Der Vergleicher 640 triggert daraufhin zweimal den Zähler 650, der daraufhin einen Zählwert 2 an die Auswerteeinrichtung 660 weitergibt. Da die Auswerteeinrichtung 660 die Abtastfrequenz des AD-Umsetzers 630, nämlich 1/$T_{AB}$-, den vom Zähler gelieferten Zahlwert N = 2 sowie die Periodendauer T des zu messenden Signals, kann sie den maximalen Amplitudenwert des zu messenden Signals gemäß Gleichung (5) berechnen.

Um den schaltungstechnischen Aufwand der Auswerteeinrichtung 660 und deren Rechenleistung reduzieren zu können, werden im Speicher 670 für mehrere Referenzsignale jeweils die ermittelte Anzahl von gezählten Abtastwerten und die dazu gehörenden maximalen Amplitudenwerte gespeichert.

Die im Speicher 670 abgelegten Werte werden vorab ermittelt, indem beispielsweise mehrere Referenzsignale, die die gleiche bekannte Frequenz besitzen, mit einer festen Abtastfrequenz abgetastet. Dann werden für jedes Referenzsignal die Anzahl an Abtastwerten ermittelt, die in den Schwellenwert 1023 umgesetzt worden sind. Mit Hilfe der Gleichung (5) wird schließlich für jedes Referenzsignal der maximale Amplitudenwert ermittelt und zusammen mit der dazu gehörenden Anzahl N in dem Speicher 670 abgelegt.

In der anliegenden Tabelle sind beispielhaft die entsprechenden Werte für Referenzsignale mit einer Frequenz von 50 Hz eingetragen, wobei die Referenzsignale mit einer Abtastfrequenz von 6,66 kHz abgetastet worden sind.

In der linken Spalte, die mit N/2 bezeichnet ist, ist die halbe Anzahl der Messwerte, welche den zulässigen Messbereich überschritten haben, eingetragen. In der mittleren Spalte, die mit I[A] gekennzeichnet ist, ist, ist der jeweilige, gemäß Gleichung (5) berechnete maximale Amplitudenwert eingetragen. In der rechten Spalte der Tabelle ist der maximale Fehler in Prozent eingetragen, der zwischen gemessenem Amplitudenwert und tatsächlichem Amplitudenwert besteht.

Das negative Vorzeichen gibt an, dass der tatsächliche maximale Amplitudenwert des zu messenden Signals immer kleiner als der gemäß Gleichung (5) berechnete maximale Amplitudenwert ist.

Diese Tatsache ist bei elektrischen Antrieben von Vorteil, die bei Überschreiten des zulässigen Nennstroms um einen vorbestimmten Betrag sicher in den Stillstand gefahren werden müssen.

Erwähnt sei an dieser Stelle, dass die in der Tabelle gezeigten Werte bis N/2 = 30 von praktischer Bedeutung sind, da z. B. Asynchronmotoren grundsätzlich nur das Siebenfache ihres Nennstroms aufnehmen können. Dies bedeutet, dass, wenn der Zähler 650 mehr als 62 aufeinander folgende Abtastwerte mit dem Zahlenwert 1023 gezählt hat, der überwachte Asynchronmotor abgeschaltet wird, da der vom Messgerät 610 ermittelte maximale Amplitudenwert von 9, 1129 mehr als dem siebenfachen Nennwert des Asynchronmotors entspricht. Angemerkt sei, dass ein Strom, der dem siebenfachen Nennwert entspricht, auf einen Kurzschluss im Motor hinweist.

Dank der Erfindung ist es möglich, die Amplitude eines Wechselsignals, dessen Kurvenform bekannt ist, außerhalb des zulässigen Arbeitsbereichs mit Hilfe eines Messgeräts abzuschätzen, welches nur zur Messung von Signalen innerhalb des zulässigen Messbereichs dimensioniert ist.

Tabelle

| N/2 | I[A] | max. Fehler (%) |
|---|---|---|
| 0 | < 1,0000 | Nennbereich |
| 1 | 1,0011 | -0,1110 |
| 2 | 1,0045 | -0,1110 |
| 3 | 1,0101 | -0,3331 |
| 4 | 1,0180 | -0,5562 |
| 5 | 1,0284 | -0,7814 |

(fortgesetzt)

| N/2 | I[A] | max. Fehler (%) |
|---|---|---|
| 6 | 1,0413 | -1,0096 |
| 7 | 1,0570 | -1,2419 |
| 8 | 1,0755 | -1,4795 |
| 9 | 1,0972 | -1,7238 |
| 10 | 1,1223 | -1,9760 |
| 11 | 1,1512 | -2,2379 |
| 12 | 1,1844 | -2,5112 |
| 13 | 1,2223 | -2,7979 |
| 14 | 1,2656 | -3,1004 |
| 15 | 1,3151 | -3,4217 |
| 16 | 1,3718 | -3,7649 |
| 17 | 1,4370 | -4,1342 |
| 18 | 1,5121 | -4,5346 |
| 19 | 1,5994 | -4,9720 |
| 20 | 1,7013 | -5,4541 |
| 21 | 1,8214 | -5,9908 |
| 22 | 1,9645 | -6,5946 |
| 23 | 2,1371 | -7,2822 |
| 24 | 2,3486 | -8,0762 |
| 25 | 2,6131 | -9,0078 |
| 26 | 2,9521 | -10,1216 |
| 27 | 3,4009 | -11,4835 |
| 28 | 4,0211 | -13,1953 |
| 29 | 4,9313 | -15,4232 |
| 30 | 6,3925 | -18,4577 |
| 31 | 9,1129 | -22,8578 |

**Patentansprüche**

1. Messvorrichtung (10) zum Messen eines periodischen Analogsignals, dessen Amplitude außerhalb eines vorbestimmten Arbeitsbereichs liegen kann, mit einer Einrichtung (20, 30, 40, 50) zum Ermitteln der Zeitdauer, während der die Amplitude des zu messenden Analogsignals außerhalb des vorbestimmten Arbeitsbereichs liegt, und einer Auswerteeinrichtung (60), die aus der ermittelten Zeitdauer und der Signalform, insbesondere der Signalfrequenz des zu messenden Analogsignals dessen maximale Amplitude berechnet,
**dadurch gekennzeichnet, dass**
die Ermittlungseinrichtung eine Abtasteinrichtung (620) zum Abtasten des zu messenden Analogsignals mit einer Abtastfrequenz und eine Einrichtung (640, 650) zum Erfassen und Zählen von aufeinanderfolgenden Abtastwerten, welche betragsmäßig größer oder gleich einem vorbestimmten Schwellenwert sind, aufweist, und dass die Auswerteeinrichtung (660) zum Berechnen der maximalen Amplitude des Analogsignals in Abhängigkeit von der Anzahl der gezählten Abtastwerte, der Abtastfrequenz und der Signalfrequenz ausgebildet ist.

2. Messvorrichtung nach Anspruch 1,
**dadurch gekennzeichnet, dass**

das Analogsignal ein sinusförmiges Signal mit einer vorbestimmten Signalfrequenz ist und dass die Auswerteeinrichtung (660) den maximalen Amplitudenwert unter Verwendung der Gleichung

$$I = \frac{1}{\sin\left(\pi\left(\frac{1}{2} - \frac{T_{AB} * N}{T}\right)\right)}$$

berechnet, wobei $T_{AB}$ der Kehrwert der Abtastfrequenz, N die Anzahl gezählter Abtastwerte, welche betragsmäßig größer oder gleich dem vorbestimmten Schwellenwert sind, und T die Periodendauer des zu messenden Analogsignals ist.

3. Messvorrichtung zum Messen eines periodischen Analogsignals, welches außerhalb eines vorbestimmten Arbeitsbereichs liegen kann, mit
   einer Abtasteinrichtung (620) zum Abtasten des Analogsignals mit einer Abtastfrequenz,
   einer Einrichtung (640, 650) zum Erfassen und Zählen von aufeinanderfolgenden Abtastwerten, welche betragsmäßig größer oder gleich einem vorbestimmten Schwellenwert sind,
   einer Speichereinrichtung (670), in der der maximale, außerhalb des vorbestimmten Arbeitsbereichs liegende Amplitudenwert mehrerer Referenzsignale und die jeweils dazugehörende Anzahl von gezählten Abtastwerten, welche betragsmäßig größer oder gleich einem vorbestimmten Schwellenwert sind, abgelegt sind, und
   einer Auswerteeinrichtung (660), die unter Ansprechen auf die von der Erfassungs- und Zähleinrichtung (640, 650) ermittelte Anzahl von Abtastwerten den dazugehörenden maximalen Amplitudenwert aus der Speichereinrichtung ausliest.

4. Messvorrichtung nach Anspruch 1, 2 oder 3,
   **gekennzeichnet durch**
   einen AD-Umsetzer (630) zum Umsetzen der Abtastwerte in entsprechende Digitalwerte.

5. Messvorrichtung nach einem der Ansprüche 1 bis 4
   **dadurch gekennzeichnet, dass**
   die Abtastfrequenz einstellbar ist.

6. Messvorrichtung nach einem der Ansprüche 1 bis 5,
   **dadurch gekennzeichnet, dass**
   der Schwellenwert mit den Grenzwerten des vorbestimmten Arbeitsbereichs zusammenfällt oder kleiner ist.

7. Gegen Überströme gesicherte Vorrichtung, insbesondere elektrische Antriebe, mit
   einer Messvorrichtung (610) nach einem der Ansprüche 1 bis 6 und einer Auslöseeinrichtung, die unter Ansprechen auf den berechneten maximalen Amplitudenwert die Vorrichtung ausschalten kann.

8. Verfahren zum Messen eines periodischen Analogsignals, dessen Amplitude außerhalb eines vorbestimmten Arbeitsbereichs liegen kann, mit
   folgenden Verfahrensschritten:

   Ermitteln der Zeitdauer, während der die Amplitude des zu messenden Analogsignals außerhalb des vorbestimmten Arbeitsbereichs liegt, und
   Berechnen der maximalen Amplitude des zu messenden Analogsignals in Abhängigkeit von der ermittelten Zeitdauer und der Signalform, insbesondere der Signalfrequenz des zu messenden Analogsignals,

   **dadurch gekennzeichnet, dass**
   der Schritt zum Ermitteln der Zeitdauer folgende Schritte aufweist:

   das zu messendes Analogsignal wird mit einer Abtastfrequenz abgetastet;
   aufeinanderfolgende Abtastwerte, welche betragsmäßig größer oder gleich einem vorbestimmten Schwellenwert sind, werden gezählt; und dass

in Abhängigkeit von der Anzahl der gezählten Abtastwerte, der Abtastfrequenz und der Signalfrequenz die maximale Amplitude des Analogsignals berechnet wird.

9. Verfahren zum Messen eines periodischen Analogsignals, welches außerhalb eines vorbestimmten Arbeitsbereichs einer verwendeten Messvorrichtung liegen kann, mit folgenden Verfahrensschritten:

für mehrere Referenzsignale werden jeweils die maximale Amplitude, welche außerhalb des vorbestimmten Arbeitsbereichs liegt, und die dazugehörende Anzahl von Abtastwerten, die betragsmäßig größer oder gleich einem Schwellenwert sind, ermittelt und gespeichert;

ein zu messendes Analogsignal wird mit einer Abtastfrequenz abgetastet;

die aufeinanderfolgenden Abtastwerte, welche betragsmäßig größer oder gleich dem vorbestimmten Schwellenwert sind, werden gezählt; und der zur Anzahl der gezählten Abtastwerte gehörende maximale Amplitudenwert wird ausgelesen.

10. Verfahren nach Anspruch 8 oder 9,
**dadurch gekennzeichnet, dass**
die Abtastwerte in Digitalwerte umgesetzt werden, und dass aufeinanderfolgende Digitalwerte, welche betragsmäßig größer oder gleich einem vorbestimmten digitalen Schwellenwert sind, gezählt werden.

**Claims**

1. Measurement device (10) for measuring a periodic analogue signal, whose amplitude can be outside a predetermined operating range, having a device (20, 30, 40, 50) for determining the time period, during which the amplitude of the analogue signal to be measured is outside the predetermined operating range, and an evaluation device (60) which calculates the maximum amplitude of the analogue signal, which is to be measured, from the determined time period and the signal form, in particular the signal frequency, of the analogue signal, **characterised in that** the determining device comprises a sampling device (620) for sampling the analogue signal, which is to be measured, at a sampling rate and comprises a device (640, 650) for detecting and counting successive sampled values which in terms of magnitude are greater than or equal to a predetermined threshold value, and that the evaluation device (660) is formed for the purpose of calculating the maximum amplitude of the analogue signal as a function of the number of counted sampled values, the sampling rate and the signal frequency.

2. Measurement device as claimed in claim 1, **characterised in that** the analogue signal is a sinusoidal signal having a predetermined signal frequency and that the evaluation device (660) calculates the maximum amplitude value using the equation

$$l = \frac{1}{\sin\left(\pi\left(\frac{1}{2} - \frac{T_{AB} * N}{T}\right)\right)}$$

where $T_{AB}$ is the reciprocal value of the sampling rate, N is the number of counted sampled values which in terms of magnitude are greater than or equal to the predetermined threshold value, and T is the periodic time of the analogue signal to be measured.

3. Measurement device for measuring a periodic analogue signal which can be outside a predetermined operating range, having a sampling device (620) for sampling the analogue signal at a sampling rate, a device (640, 650) for detecting and counting successive sampled values which in terms of magnitude are greater than or equal to a predetermined threshold value, a memory device (670) which stores the maximum amplitude value of several reference signals which is outside the predetermined operating range, and the respectively associated number of counted sampled values which in terms of magnitude are greater than or equal to a predetermined threshold value, and an evaluation device (660) which reads out the associated maximum amplitude value from the memory device in response to the number of sampled values determined by the detecting and counting device (640, 650).

4. Measurement device as claimed in claim 1, 2 or 3, **characterised by** an AD-converter (630) for converting the sampled values into corresponding digital values.

5. Measurement device as claimed in any one of claims 1 to 4, **characterised in that** the sampling rate is adjustable.

6. Measurement device as claimed in any one of claims 1 to 5, **characterised in that** the threshold value coincides with or is less than the limit values of the predetermined operating range.

7. Device protected against over-currents, in particular electrical drives, having a measurement device (610) as claimed in any one of claims 1 to 6, and a disconnecting device which can switch off the device in response to the calculated maximum amplitude value.

8. Method for measuring a periodic analogue signal, whose amplitude can be outside a predetermined operating range, comprising the method steps of determining the time period, during which the amplitude of the analogue signal to be measured is outside the predetermined operating range, and
calculating the maximum amplitude of the analogue signal, which is to be measured, as a function of the determined time period and the signal form, in particular the signal frequency, of the analogue signal to be measured, **characterised in that** the step for determining the time period comprises the steps of:

sampling the analogue signal, which is to be measured, at a sampling rate;
counting successive sampled values which in terms of magnitude are greater than or equal to a predetermined threshold value; and that
the maximum amplitude of the analogue signal is calculated as a function of the number of counted sampled values, the sampling rate and the signal frequency.

9. Method for measuring a periodic analogue signal, which can be outside a predetermined operating range of a measurement device which is used, comprising the method steps of
determining and storing, for several reference signals, in each case the maximum amplitude, which is outside the predetermined operating range, and the associated number of sampled values which in terms of magnitude are greater than or equal to a threshold value;
sampling an analogue signal, which is to be measured, at a sampling rate;
counting the successive sampled values which in terms of magnitude are greater than or equal to the predetermined threshold value; and
reading out the maximum amplitude value associated with the number of counted sampled values.

10. Method as claimed in claim 8 or 9, **characterised in that** the sampled values are converted into digital values and that successive digital values which in terms of magnitude are greater than or equal to a predetermined digital threshold value are counted.

**Revendications**

1. Dispositif de mesure (10) pour mesurer un signal analogique périodique, dont l'amplitude peut se situer en dehors de la plage de travail prédéfinie, doté d'un système (20, 30, 40, 50) pour déterminer la durée pendant laquelle l'amplitude du signal analogique à mesurer se situe en dehors de la plage de travail prédéfinie, et d'un système d'analyse (60), qui calcule à partir de la durée déterminée et de la forme de signal, en particulier de la fréquence de signal du signal analogique à mesurer, son amplitude maximale,
**caractérisé en ce que**
le système de détermination présente un système de balayage (620) pour le balayage du signal analogique à mesurer avec une fréquence de balayage et un système (640, 650) pour la détection et le comptage de valeurs de balayage consécutives, qui sont supérieures ou égales au niveau de la somme à une valeur seuil prédéfinie, et **en ce que**
le système d'analyse (660) est conçu pour calculer l'amplitude maximale du signal analogique en fonction du nombre des valeurs de balayage comptées, de la fréquence de balayage et de la fréquence de signal.

2. Dispositif de mesure selon la revendication 1,
**caractérisé en ce que**
le signal analogique est un signal sinusoïdal avec une fréquence de signal prédéfinie et **en ce que** le système d'analyse (660) calcule la valeur d'amplitude maximale en utilisant l'équation suivante

$$I = \frac{1}{\sin\left(\pi\left(\frac{1}{2} - \frac{T_{AB} * N}{T}\right)\right)}$$

dans laquelle $T_{AB}$ est la valeur réciproque de la fréquence de balayage, N le nombre de valeurs de balayage comptées, qui sont supérieures ou égales au niveau de la somme à la valeur seuil prédéfinie, et T la durée de période du signal analogique à mesurer.

3. Dispositif de mesure pour mesurer un signal analogique périodique, qui peut se situer en dehors d'une plage de travail prédéfinie, doté d'un dispositif de balayage (620) pour le balayage du signal analogique avec une fréquence de balayage, un système (640, 650) pour la détection et le comptage de valeurs de balayage consécutives, qui sont supérieures ou égales au niveau de la somme à une valeur seuil prédéfinie,
d'un système de stockage (670), dans lequel la valeur d'amplitude maximale, se situant en dehors de la plage de travail prédéfinie de plusieurs signaux de fréquence et le nombre respectif correspondant de valeurs de balayage comptées, lesquelles sont supérieures ou égales au niveau de la somme à une valeur seuil prédéfinie, sont déposés, et
d'un système d'analyse (660), qui lit la valeur d'amplitude maximale correspondante à partir du système de stockage en réponse au nombre de valeurs de balayage qui est déterminé par le système de détection et de comptage (640, 650).

4. Système de mesure selon la revendication 2 ou 3,
**caractérisé par**
un convertisseur analogique-numérique (630) pour la conversion des valeurs de balayage en valeurs numériques correspondantes.

5. Dispositif de mesure selon l'une quelconque des revendications 1 à 4,
**caractérisé en ce que**
la fréquence de balayage est réglable.

6. Dispositif de mesure selon l'une quelconque des revendications 1 à 5,
**caractérisé en ce que**
la valeur seuil coïncide avec les valeurs limites de la plage de travail prédéfinie ou est inférieure à celles-ci.

7. Dispositif protégé contre des surintensités de courant, en particulier des entraînements électriques, doté
d'un dispositif de mesure (610) selon l'une quelconque des revendications 1 à 6 et d'un système de déclenchement, qui peut déconnecter le dispositif en réaction à la valeur d'amplitude maximale calculée.

8. Procédé pour la mesure d'un signal analogique périodique, dont l'amplitude peut se situer en dehors d'une plage de travail prédéfinie, comprenant les étapes de procédé suivantes :

détermination de la durée pendant laquelle l'amplitude du signal analogique à mesurer se situe en dehors de la plage de travail prédéfinie, et
calcul de l'amplitude maximale du signal analogique à mesurer en fonction de la durée déterminée et de la forme de signal, en particulier de la fréquence du signal analogique à mesurer,
**caractérisé en ce que** l'étape pour déterminer la durée présente les étapes suivantes :

le signal analogique à mesurer est balayé avec une fréquence de balayage ;
des valeurs de balayage consécutives, qui sont supérieures ou égales au niveau de la somme à une valeur seuil prédéfinie, sont comptées ; et **en ce que**
l'amplitude maximale du signal analogique est calculée en fonction du nombre des valeurs de balayage comptées, de la fréquence de balayage et de la fréquence de signal.

9. Procédé pour mesurer un signal analogique périodique, qui peut se situer en dehors d'une plage de travail prédéfinie d'un dispositif de mesure utilisé, comprenant les étapes de procédé suivantes :

pour plusieurs signaux de référence, on détermine et on mémorise à chaque fois l'amplitude maximale qui se situe en dehors de la plage de travail prédéfinie et le nombre correspondant de valeurs de balayage qui sont supérieures ou identiques au niveau de la somme à une valeur seuil ;
un signal analogique à mesurer est balayé avec une fréquence de balayage ;
les valeurs de balayage consécutives, qui sont supérieures ou identiques au niveau de la somme à la valeur seuil prédéfinie, sont comptées ; et la valeur d'amplitude maximale faisant partie du nombre des valeurs de balayage comptées est lue.

10. Procédé selon la revendication 8 ou 9,
**caractérisé en ce que**
les valeurs de balayage sont converties en valeurs numériques, et **en ce que** des valeurs numériques consécutives, qui sont supérieures ou identiques au niveau de la somme à une valeur seuil numérique prédéfinie, sont comptées.

900

940 61 824 822 610 930 910

61

760

765

S1 digitale Aus-gänge

Modu-lator

analoges Eingangssignal

Stromwandler

L1 L2 L3

E⁻

820

820

&

L

R

R1

828

270

800

762

digitale Ein-gänge

S3

S1

63

945 63 830 840 850 200

T1 T2 T3

920

Fig.1

EP 2 017 867 B1

Fig. 2

610

analoges Messsignal

Abtast- und Halteglied — 620

AD-Umsetzer — 630

Schwell-wert

Vergleicher — 640

Zähler — 650

Auswerte-einrichtung — 660

Tabellen-speicher — 670

Fig. 3

EP 2 017 867 B1

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4625283 A
- US 4630218 A